# EUROPÄISCHE PATENTSCHRIFT

(11) **EP 3 319 234 B1**
(45) Veröffentlichungstag und Bekanntmachung des Hinweises auf die Patenterteilung: **11.03.2020**
(21) Anmeldenummer: 17187013.2
(22) Anmeldetag: 21.08.2017
(51) Int. Cl.: H03M 1/18, H04R 25/00

(54) **VERFAHREN ZUM BETRIEB EINES HÖRGERÄTS**
METHOD FOR OPERATING A HEARING AID
PROCÉDÉ DE FONCTIONNEMENT D'UN DISPOSITIF DE CORRECTION AUDITIVE

(30) Priorität: 04.11.2016 DE 102016221692
(43) Veröffentlichungstag der Anmeldung: 09.05.2018
(73) Patentinhaber: Sivantos Pte. Ltd., Singapore 539775 (SG)
(72) Erfinder: PETRAUSCH, Stefan, 91056 Erlangen (DE); PILGRIM, Thomas, 91054 Erlangen (DE)
(74) Vertreter: FDST Patentanwälte

(56) Entgegenhaltungen:
- WO-A1-01/26418
- WO-A1-02/17496
- GB-A- 2 057 228

## Beschreibung

Die Erfindung betrifft ein Verfahren zum Betrieb eines Hörgeräts. Das Hörgerät ist bevorzugt ein Hörhilfegerät. Die Erfindung betrifft ferner ein derartiges Hörgerät.

Personen, die unter einer Verminderung des Hörvermögens leiden, verwenden üblicherweise ein Hörhilfegerät. Hierbei wird meist mittels eines elektromechanischen Schallwandlers ein Umgebungsschall erfasst. Die erfassten elektrischen Signale werden mittels einer Verstärkerschaltung bearbeitet und mittels eines weiteren elektromechanischen Wandlers in den Gehörgang der Person eingeleitet. Es sind unterschiedliche Arten von Hörhilfegeräten bekannt. Die sogenannten "Hinter-dem-Ohr-Geräte" werden zwischen Schädel und Ohrmuschel getragen. Die Einleitung des verstärkten Schallsignals in den Gehörgang erfolgt hierbei mittels eines Schallschlauchs. Eine weitere gebräuchliche Ausgestaltung eines Hörhilfegeräts ist ein "im-Ohr-Gerät", bei dem das Hörhilfegerät selbst in den Gehörgang eingeführt wird. Mittels dieses Hörhilfegeräts wird folglich der Gehörgang zumindest teilweise verschlossen, sodass außer dem mittels des Hörhilfegeräts erzeugten Schallsignalen kein weiterer Schall - oder lediglich in stark vermindertem Maß - Schall in den Gehörgang eindringen kann.

Um eine möglichst ausgeprägte Miniaturisierung des Hörhilfegeräts zu erreichen, sind diese meist in digitaler Technik aufgebaut. Hierbei wird ein analoges Eingangssignal mittels eines A/D-Wandlers in ein digitales Signal gewandelt, welches mittels eines Signalprozessors an die Bedürfnisse des Hörgeschädigten angepasst wird. Ein normales Hörspektrum umfasst einen Bereich von bis 130 dB. Eine A/D-Wandlung über einen derartigen Hörspektrumsbereich ist mittels eines vergleichsweise klein bauenden Hörhilfegeräts nicht möglich. Folglich kann mittels des Signalprozessors lediglich ein bestimmter Bereich des Hörspektrums verarbeitet werden. Bei einem vergleichsweise großen Eingangssignal kann der A/D-Wandler übersteuern, was zu ungewollten Verzerrungen ("Clippings") führt. Falls hingegen das Eingangssignal zu gering ist, ist lediglich ein vergleichsweise schlechtes Signal-zu-Rausch-Verhältnis ("S/N-Ratio") verfügbar.

Um diesen Effekten entgegenzuwirken, weist das Hörhilfegerät meist einen analogen Vorverstärker auf, dessen Signal über den A/D-Wandler zu dem digitalen Signalprozessor geleitet wird. Hierbei wird mittels des Vorverstärkers sichergestellt, dass das dem Verstärker zugeleitete Signal stets unterhalb eines gewissen Grenzpegels verbleibt, sodass die Einbringung von unerwünschten Artefakten unterbunden ist. Bei einer vergleichsweise geringen Verstärkung des Vorverstärkers jedoch, also wenn ein vergleichsweise ausgeprägtes Eingangssignal vorliegt, oder vorgelegen hat, und der Vorverstärker noch weiter mit der geringen Verstärkung angesteuert wird, wird ein etwaiges mittels des A/D-Wandlers eingebrachtes Rauschen mittels des Verstärkers vergleichsweise ausgeprägt verstärkt. Dies ist teilweise von dem Hörhilfegeräteträger wahrnehmbar und führt zu einem unerwünschten akustischen Eindruck. Falls in periodischen Abständen vergleichsweise ausgeprägte Lautsignale auftreten, ist somit für den Hörhilfegeräteträger stets im Anschluss für einen bestimmten Zeitraum ein Rauschen wahrnehmbar, welches unangenehm ist.

Aus WO 02/17496 A1 ist ein Verfahren zur Einstellung eines Signallevels bekannt.

In WO 01/26418 A1 ist ein Verfahren zur Verstärkung von Sprachsignalkomponenten in einem Hörgerät offenbart.

GB 2 057 228 A zeigt ein Verfahren zum adaptiven Filtern von Störschall aus einem Signal, das Informationen umfasst.

Der Erfindung liegt die Aufgabe zugrunde, ein besonders geeignetes Verfahren zum Betrieb eines Hörgeräts sowie ein besonders geeignetes Hörgerät anzugeben, wobei insbesondere eine Audioqualität verbessert ist.

Erfindungsgemäß wird diese Aufgabe hinsichtlich des Verfahrens durch die Merkmale des Anspruchs 1 und hinsichtlich des Hörgeräts durch die Merkmale des Anspruchs 7 gelöst. Vorteilhafte Weiterbildungen und Ausgestaltungen sind Gegenstand der jeweiligen Unteransprüche.

Das Verfahren dient dem Betrieb eines Hörgeräts. Beispielsweise ist das Hörgerät ein Kopfhörer oder umfasst einen Kopfhörer. Besonders bevorzugt ist das Hörgerät jedoch ein Hörhilfegerät. Das Hörhilfegerät dient der Unterstützung einer unter einer Verminderung des Hörvermögens leidenden Person. Mit anderen Worten ist das Hörhilfegerät ein medizinisches Gerät, mittels dessen beispielsweise ein partieller Hörverlust ausgeglichen wird. Das Hörhilfegerät ist beispielsweise ein "receiver-in-the-canal"-Hörhilfegerät (RIC; Ex-Hörer-Hörhilfegerät), ein Im-Ohr-Hörhilfegerät, wie ein "in-the-ear"-Hörhilfegerät, ein "in-the-canal"-Hörhilfegerät (ITC) oder ein "complete-in-canal"-Hörhilfegerät (CIC), eine Hörbrille, ein Taschenhörhilfegerät, ein Knochenleitungs-Hörhilfegerät oder ein Implantat. Besonders bevorzugt ist das Hörhilfegerät ein Hinter-dem-Ohr-Hörhilfegerät ("Behind-the-Ear"-Hörhilfegerät), das hinter einer Ohrmuschel getragen wird.

Das Verfahren sieht vor, dass ein erstes analoges Signal bereitgestellt wird. Das erste analoge Signal ist beispielsweise ein Eingangssignal. Anhand des ersten analogen Signals wird mittels eines Vorverstärkers ein zweites analoges Signal erstellt. Der Vorverstärker arbeitet anhand von Analog-Technik. Mittels des Vorverstärkers wird das erste analoge Signal beispielsweise zu dem zweiten analogen Signal verstärkt oder gedämpft. Vorzugsweise entspricht das zweite analoge Signal dem verstärkten ersten analogen Signal. Insbesondere weist das zweite analoge Signal eine größere maximale Amplitude und/oder durchschnittliche Amplitude als das erste analoge Signal auf.
Zweckmäßigerweise wird das erste analoge Signal mittels des Vorverstärkers breitbandig verstärkt. Mit anderen Worten werden nicht einzelne Frequenzen spezifisch mittels des Vorverstärkers verändert. Vielmehr werden sämtliche Frequenzen des ersten analogen Signals mittels des Vorverstärkers, insbesondere in gleicher Weise, zu dem zweiten analogen Signal verändert.

In einem sich hieran anschließenden Arbeitsschritt wird mittels eines A/D-Wandlers ("Analog zu Digital"-Wandler) anhand des zweiten analogen Signals ein erstes digitales Signal (Wort) erstellt. Das erste digitale Signal hat hierbei beispielsweise eine Tiefe von 16 Bit oder 32 Bit. Beispielsweise ist zwischen den Vorverstärker und den A/D-Wandler ein weiteres Modul signaltechnisch geschaltet, mittels dessen das zweite Signal verändert wird. Alternativ hierzu wird das zweite analoge Signal von dem Vorverstärker direkt zu dem A/D-Wandler geleitet. Das erste digitale Signal entspricht vorzugsweise dem in die digitale Domäne transferierten zweiten analogen Signal.

Anhand des ersten digitalen Signals wird mittels eines Verstärkers ein zweites digitales Signal erstellt. Der Verstärker ist ein digitaler Verstärker. Insbesondere wird hierbei das erste digitale Signal zu dem zweiten digitalen Signal verstärkt. Das zweite digitale Signal entspricht insbesondere dem verstärkten ersten digitalen Signal. Anhand des zweiten digitalen Signals wird mittels einer Rauschunterdrückungseinheit ein drittes digitales Signal erstellt. Mit anderen Worten wird das zweite digitale Signal signaltechnisch von dem Verstärker zu der Rauschunterdrückungseinheit geleitet, beispielsweise direkt. Alternativ hierzu ist zwischen dem Verstärker und der Rauschunterdrückung signaltechnisch ein weiteres Modul angeordnet, mittels dessen das zweite digitale Signal verändert wird. Mittels der Rauschunterdrückungseinheit wird ein Rauschen innerhalb des zweiten digitalen Signals gedämpft, sodass bei dem dritten digitalen Signal ein Rauschen im Vergleich zu dem zweiten digitalen Signal reduziert ist.

Insbesondere wird mittels des Verstärkers oder eines zwischen dem Verstärker und der Rauschunterdrückungseinheit angeordneten Frequenzfilters das dritte digitale Signal in bestimmte Frequenzbänder aufgeteilt, wobei mittels der Rauschunterdrückungseinheit ein Rauschen in dem jeweiligen Frequenzband reduziert wird. Hierbei ist das Maß der Reduzierung insbesondere unterschiedlich zwischen den einzelnen Frequenzbändern. Mit anderen Worten erfolgt die Rauschunterdrückung mittels der Rauschunterdrückungseinheit frequenzabhängig. Der Vorverstärker, der Verstärker und die Rauschunterdrückungseinheit werden anhand eines das erste digitale Signal charakterisierenden Werts eingestellt. Insbesondere wird die Verstärkung des Vorverstärkers und/oder des Verstärkers anhand des charakterisierenden Werts eingestellt. Zweckmäßigerweise wird ein Verstärkungsfaktor des Vorverstärkers reduziert oder ein Dämpfungsfaktor des Vorverstärkers erhöht, falls der Pegel des ersten digitalen Signals oberhalb eines Grenzwerts ist. Mit anderen Worten wird als charakterisierender Wert der Pegel des ersten digitalen Signals herangezogen.

Sofern folglich das erste analoge Signal einen vergleichsweise hohen Pegel aufweist, weist auch das erste digitale Signal einen vergleichsweise hohen Pegel auf. Um eine Ausbildung von Artefakten innerhalb des ersten digitalen Signals zu vermeiden, wird der Verstärkungsfaktor des Vorverstärkers reduziert, sodass das erste digitale Signal einen verringerten Pegel aufweist. Infolgedessen ist eine Ausbildung von Artefakten aufgrund der begrenzten Aussteuerbarkeit des A/D-Wandlers vermieden, insbesondere ein "Clipping". Sofern der Pegel unterhalb eines zweiten Grenzwerts ist, wird insbesondere eine Verstärkung des Vorverstärkers vergrößert oder eine Dämpfung des Vorverstärkers verkleinert. Infolgedessen weist das zweite analoge Signal einen vergrößerten Pegel auf. Das mittels des A/D-Wandlers eingebrachte Rauschen ist im Wesentlichen konstant. Sobald nun das zweite analoge Signal einen vergrößerten (Signal-)Pegel aufweist, weist das das erste digitale Signal ein verbessertes Signal-zu-Rausch-Verhältnis auf.

Zusammenfassend weist das zweite digitale Signal je nach Ansteuerung des Vorverstärkers ein verändertes Signal-zu-Rausch-Verhältnis auf. Mittels Einstellung der Rauschunterdrückungseinheit anhand des Wertes, anhand dessen der Vorverstärker eingestellt wird, wird dies berücksichtigt, und somit die Rauschunterdrückungseinheit auf die geänderte Ansteuerung des Vorverstärkers eingestellt, weswegen ein in dem zweiten digitalen Signal vorhandenes Rauschen vergleichsweise effektiv identifiziert werden kann. Infolgedessen ist die Audioqualität des Hörgeräts verbessert.

Beispielsweise ist eine stufenlose Einstellung des Vorverstärkers vorgesehen. Alternativ hierzu weist der Vorverstärker eine Anzahl von Stufen auf, wobei jede Stufe zu einem bestimmten Wertebereich des charakterisierenden Werts korrespondiert. Besonders bevorzugt weist der Vorverstärker lediglich zwei Einstellungen auf. Mit anderen Worten wird das zweite analoge Signal entweder anhand einer ersten Einstellung oder anhand einer zweiten Einstellung erstellt. Auf diese Weise ist ein Berechnungsaufwand vereinfacht. Beispielsweise beträgt der Unterschied des Verstärkungsfaktors zwischen den beiden Einstellungen zwischen 5 dB und 20 dB, zwischen 10 dB und 15 dB und ist insbesondere gleich 10 dB, wobei insbesondere eine Abweichung von +/- 10%, 5%, 2% oder 0% mit umfasst ist.

Zweckmäßigerweise wird das dritte digitale Signal an eine Steuereinheit, beispielsweise einen Mikrochip, insbesondere einen Signalprozessor, weitergeleitet, mittels dessen eine weitere Anpassung des dritten digitalen Signals erfolgt. Beispielsweise wird mittels der Steuereinheit ein bestimmtes Frequenzband gedämpft oder verstärkt. Zweckmäßigerweise ist die Art der Anpassung des dritten Signals an Bedürfnisse eines Trägers des Hörgeräts angepasst. Das auf diese Weise bearbeitete Signal wird vorzugsweise an einen Hörer weitergeleitet, der beispielsweise digital ausgestaltet ist. Alternativ hierzu wird das Signal an einen D/A-Wandler ("Digital zu Analog"-Wandler) geleitet, mittels dessen der Hörer angesteuert ist. Geeigneterweise wird das dritte digitale Signal direkt an den D/A-Wandler bzw. an den Hörer geleitet.

Beispielsweise wird der charakterisierende Wert des ersten digitalen Signals anhand des ersten digitalen Signals direkt ermittelt. Beispielsweise wird der charakterisierende Wert direkt gemessen. In einer Alternative hierzu wird der charakterisierende Wert des ersten digitalen Signals anhand des ersten analogen Signals unter Heranziehung der Einstellung des Vorverstärkers sowie des A/D-Wandlers berechnet. Auf diese Weise kann der Vorverstärker bereits angepasst werden, bevor eine Ausbildung von Artefakten aufgrund einer Übersteuerung des A/D-Wandlers aufgrund eines zu hohen Eingangspegels des zweiten analogen Signals auftritt.

Das erste analoge Signal wird vorzugsweise mittels eines Mikrofons bereitgestellt. Mit anderen Worten wird mittels des Mikrofons das erste analoge Signal aufgenommen. In einer Alternative hierzu wird das erste analoge Signal mittels eines Empfängers erfasst. Der Empfänger arbeitet hierbei beispielsweise induktiv, oder es werden Radiowellen mittels des Senders empfangen.

Geeigneterweise wird der Verstärker derart eingestellt, dass ein Verstärkungsverhältnis zwischen dem ersten analogen Signal und dem zweiten digitalen Signal konstant ist. Folglich wird, falls eine Verstärkung des Vorverstärkers erhöht wird, die Verstärkung des Verstärkers verringert und umgekehrt. Infolgedessen ist eine vergleichsweise große dynamische Bandbreite des Hörgeräts realisiert, wobei vergleichsweise klein bauende und kostengünstige Komponenten verwendet werden können. Auch wird der A/D-Wandler meist in dessen optimalen Betriebsbereich betrieben, wobei der Verstärkungsfaktor des Hörgeräts im Wesentlichen nicht beeinflusst ist.

Beispielsweise wird der charakterisierende Wert stets an die Rauschunterdrückungseinheit sowie den Vorverstärker übermittelt. Besonders bevorzugt jedoch wird lediglich eine Änderung des charakterisierenden Werts an die Rauschunterdrückungseinheit übermittelt. Insbesondere wird hierbei auch lediglich die Änderung an den Vorverstärker sowie den Verstärker übermittelt. Zweckmäßigerweise wird lediglich übermittelt, ob der charakterisierende Wert oberhalb oder unterhalb eines bestimmten Grenzwerts ist. Auf diese Weise ist eine zu übermittelnde Informationsmenge/Informationstiefe verringert.

Zweckmäßigerweise wird anhand des charakterisierenden Werts eine Adaptionsgeschwindigkeit eines Rausch-Pegel-Messers der Rauschunterdrückungseinheit eingestellt. Insbesondere wird eine Zeitkonstante des Rausch-Pegel-Messers zu einer adaptiven Anpassung verringert. Mittels des Rausch-Pegel-Messers wird bei Betrieb ein Pegel des zweiten digitalen Signals erfasst. Geeigneterweise weist die Rauschunterdrückungseinheit einen Rausch-Pegel-Messer auf, mittels dessen der Rauschpegel des zweiten digitalen Signals erfasst wird. Der Rauschpegel ist hierbei beispielsweise der aktuelle Pegel des zweiten digitalen Signals oder ein zeitlicher Mittelwert hiervon. Alternativ oder besonders bevorzugt in Kombination hierzu weist die Rauschunterdrückungseinheit einen Rausch-Pegel-Messer auf, mittels dessen ein Grundrauschen ("noise floor") des zweiten digitalen Signals erfasst wird. Zweckmäßigerweise werden die Adaptionsgeschwindigkeiten der Rausch-Pegel-Messer der Rauschunterdrückungseinheit anhand des charakterisierenden Werts eingestellt. Zusammenfassend werden die Zeitkonstanten des Rausch-Pegel-Messers zur Erfassung des Pegels und/oder des Grundrauschens angepasst. Zweckmäßigerweise werden die Adaptionsgeschwindigkeiten/Zeitkonstanten lediglich dann angepasst, wenn die Änderung des charakterisierenden Werts an die Rauschunterdrückungseinheit übermittelt wird, und/oder dann, wenn eine Einstellung des Vorverstärkers verändert wird. Auf diese Weise ist eine Anpassung der Rauschunterdrückungseinheit auf das geänderte Signal-zu-Rausch-Verhältnis eingestellt, das innerhalb des ersten digitalen Signals aufgrund der geänderten Ansteuerung des Vorverstärkers vorhanden ist. Mittels des Rausch-Pegel-Messers wird insbesondere ein erwartetes Rauschen anhand von bestimmten Eigenschaften des zweiten digitalen Signals ermittelt.

Zweckmäßigerweise wird anhand des charakterisierenden Werts eine erwartete Rauschform angepasst. Hierbei wird beispielsweise eine Schwelle angepasst, anhand derer ein Rauschen identifiziert ist. Insbesondere ist unterhalb eines bestimmten Pegels des zweiten digitalen Signals ein Rauschen bestimmt. Diese Anteile des zweiten digitalen Signals werden mittels der Rauschunterdrückungseinheit entfernt, sodass das dritte digitale Signal diese Anteile nicht aufweist. Die anderen Komponenten des dritten digitalen Signals stimmen bevorzugt jedoch mit denen des zweiten digitalen Signals überein. Alternativ oder in Kombination hierzu wird ein Spektrum der erwarteten Rauschform (Rauschspektrum) angepasst. Insbesondere, sofern noch weitere Bestandteile des Hörgeräts ein Rauschen einbringen, beispielsweise ein Mikrofon, weist das zweite digitale Signal ein Rauschen auf, welches unterschiedliche Komponenten umfasst. Aufgrund der Einstellung des Vorverstärkers werden bestimmte Rauschkomponenten verstärkt, wohingegen die aufgrund des A/D-Wandlers eingebrachten Rauschkomponenten von der Einstellung des Vorverstärkers unabhängig sind. Somit ist je nach Einstellung des Vorverstärkers das Spektrum des Rauschens unterschiedlich. Mittels Anpassung der erwarteten Rauschform, insbesondere des Spektrums, innerhalb der Rauschunterdrückungseinheit wird diese auf die geänderten Rauschkomponenten angepasst, sodass diese vergleichsweise effizient identifiziert und reduziert werden können.

Beispielsweise werden bei Fertigung die Rauschformen/Rauschspektren gemessen, die sich bei bestimmten Einstellungen des Vorverstärkers ergeben. Insbesondere werden diese Formen in der Rauschunterdrückungseinheit in Abhängigkeit der jeweiligen Einstellung des Vorverstärkers hinterlegt. Zweckmäßigerweise weist der Vorverstärker lediglich zwei unterschiedliche Einstellungen in Abhängigkeit des charakterisierenden Werts auf, sodass lediglich zwei erwartete Rauschformen/Rauschspektren in der Rauschunterdrückungseinheit hinterlegt sind, was Speicherplatz reduziert. Beispielsweise werden die Rauschformen/Rauschspektren für jedes Hörgerät separat ermittelt. Insbesondere erfolgt eine Testmessung bei dem Hörgerät, und/oder bei Betrieb des Hörgeräts, beispielsweise mittels Ausführen eines bestimmten Programms des Hörgeräts. Alternativ hierzu wird für jeden Typ von Hörgerät das jeweilige Spektrum der Rauschform ermittelt und in jedem Hörgerät des jeweiligen Typs hinterlegt.

Beispielsweise weist die Rauschunterdrückungseinheit eine erste Pegelanpasseinheit und eine zweite Pegelanpasseinheit auf. Mittels der ersten Pegelanpasseinheit wird anhand des zweiten digitalen Signals ein erstes digitales Hilfssignal erstellt. Anhand des ersten digitalen Hilfssignals wird mittels eines Rausch-Pegel-Messers der Rauschunterdrückungseinheit ein zweites digitales Hilfssignal erstellt. Das zweite digitale Hilfssignal entspricht hierbei einem Grundrauschen innerhalb des ersten digitalen Hilfssignals. Anhand des zweiten digitalen Hilfssignals wird mittels der zweiten Pegelanpasseinheit ein Grundrauschen erstellt, welches zu dem Rauschen des zweiten digitalen Signals korrespondiert. Hierbei unterscheidet sich das Grundrauschen zu dem zweiten digitalen Hilfssignals insbesondere lediglich durch den Pegel.

Beispielsweise wird mittels der ersten/zweiten Pegelanpasseinheit ein Pegel reduziert, sodass das erste digitale Hilfssignal im Vergleich zum zweiten digitalen Signal bzw. das Grundrauschen im Vergleich zum zweiten digitalen Hilfssignal einen veränderten Pegel aufweist. Diese Veränderung ist beispielsweise breitbandig und konstant für sämtliche Frequenzen. Alternativ hierzu wird mittels der ersten/zweiten Pegelanpasseinheit der Pegel von bestimmten Frequenzen erhöht und/oder verringert, sodass das Frequenzspektrum des ersten digitalen Hilfssignals im Vergleich zum zweiten digitalen Signal bzw. des Grundrauschens im Vergleich zum zweiten digitalen Hilfssignal verändert ist. Hierbei ist die Veränderung entweder eine Verschiebung des Frequenzspektrums des zweiten digitalen Signals und/oder eine Verzerrung.

Insbesondere ist die zweite Pegelanpasseinheit invers zur ersten Pegelanpasseinheit ausgestaltet/betrieben. Mit anderen Worten wird mittels der zweiten Pegelanpasseinheit die inverse Operation durchgeführt, die mittels der ersten Pegelanpasseinheit durchgeführt wird. Mittels der zweiten Pegelanpasseinheit ist wird somit der Pegel von bestimmten Frequenzen geändert wird, wobei jeder Frequenz insbesondere der inverse Faktor zugeordnet wird, der bei der ersten Pegelanpasseinheit verwendet wird. Mittels der ersten Pegelanpasseinheit wird das zweite digitale Signal auf das erste digitale Hilfssignal transformiert, wobei insbesondere sichergestellt ist, dass das erste digitale Hilfssignal zu einem bestimmten Arbeitsbereich des Rausch-Pegel-Messers korrespondiert. Vorzugsweise ist die erste Pegelanpasseinheit derart eingestellt, dass der Pegel des ersten digitalen Hilfssignals stets in einem bestimmten Bereich ist. Insbesondere ist mittels der ersten Pegelanpasseinheit sichergestellt, dass das in dem ersten digitalen Hilfssignal vorhandene Rauschen stets einen bestimmten Pegelwert aufweist. Mit anderen Worten ist der Rauschlevel des ersten digitalen Hilfssignals stets gleich groß. Zweckmäßigerweise erfolgt die Ermittlung des Rauschens in dem ersten digitalen Hilfssignal anhand einer Adaption. Aufgrund der ersten Pegelanpasseinheit wird eine Adaption der Rauschunterdrückungseinheit, insbesondere einer Unterdrückungseinheit der Rauschunterdrückungseinheit, vergleichsweise gering beeinflusst, sodass stets zuverlässig das Rauschen erkannt wird. Zweckmäßigerweise ist die erste Pegelanpasseinheit derart angesteuert, dass eine Adaption der Unterdrückungseinheit bei einer Änderung des Vorverstärkers vergleichsweise gering beeinflusst wird.

Die erste Pegelanpasseinheit und die zweite Pegelanpasseinheit anhand des charakterisierenden Werts eingestellt. Der Rausch-Pegel-Messer wird insbesondere unabhängig von dem charakterisierenden Wert eingestellt. Zweckmäßigerweise wird der Rausch-Pegel-Messer ein einziges Mal eingestellt, beispielsweise bei Fertigung des Hörgeräts. Zumindest jedoch ist der Rausch-Pegel-Messer nicht abhängig von dem charakterisierenden Wert eingestellt. Geeigneterweise wird mittels der ersten Pegelanpasseinheit ein erwartetes Rauschlevel innerhalb des ersten digitalen Hilfssignals im Wesentlichen konstant gehalten, sodass der erwartete Rauschlevel im Wesentlichen unabhängig von dem charakterisierenden Wert ist. Folglich kann das Rauschen vergleichsweise zuverlässig identifiziert werden. Mittels der zweiten Pegelanpasseinheit wird das zweite digitale Hilfssignal wiederum auf den Pegel des zweiten digitalen Signals gebracht.

Zur Erstellung des dritten digitalen Signals anhand des zweiten digitalen Signals wird ein Wiener-Filter herangezogen. Das Wiener-Filter ist vorzugsweise ein Bestandteil der Unterdrückungseinheit, sofern diese vorhanden ist. Mittels des Wiener-Filters ist eine vergleichsweise effiziente Rauschunterdrückung ermöglicht.

Insbesondere ist der Anteil der Reduktion des Rauschens in Abhängigkeit des charakterisierenden Werts eingestellt. Hierbei wird vorzugsweise der maximal zu reduzierende Anteil verändert. Mit anderen Worten wird der als Rauschen identifizierte Signalanteil innerhalb des zweiten digitalen Signals in Abhängigkeit des charakterisierenden Werts eingestellt. Vorzugsweise wird der Anteil der Reduktion des Rauschens erhöht, wenn ein Verstärkungsfaktor des Vorverstärkungsfaktors erniedrigt ist. Insbesondere ist der Anteil der Reduktion des Rauschens invers proportional zu dem Verstärkungsfaktor des Vorverstärkers eingestellt. Mit anderen Worten ist der Anteil der Reduktion des Rauschens erhöht, falls der Verstärkungsfaktor des Vorverstärkers erniedrigt ist. Aufgrund der verringerten Verstärkung ist ein mittels des A/D-Wandlers in das erste digitale Signal eingebrachte Rauschen im Vergleich zu dem Signalanteil des ersten digitalen Signals erhöht. Mittels Anhebung des Anteils der Reduktion des Rauschens ist somit eine vergleichsweise effiziente Unterdrückung des Rauschens ermöglicht. Insbesondere wird hierfür ein als Rauschen identifizierter Signalanteil vergrößert. Mit anderen Worten werden mehr Signalanteile innerhalb des zweiten digitalen Signals als Rauschen identifiziert, welches mittels der Rauschunterdrückungseinheit entfernt wird, sodass das dritte digitale Signal diese Komponente nicht aufweist.

Das Hörgerät weist einen Vorverstärker und einen einem diesem signaltechnisch nachgeschalteten A/D-Wandler auf. Diesem ist signaltechnisch ein Verstärker nachgeschaltet, und diesem ist eine Rauschunterdrückungseinheit nachgeschaltet. Der Vorverstärker ist ein analoger Vorverstärker, mittels dessen bei Betrieb vorzugsweise ein analoges Signal verstärkt oder gedämpft wird. Der Vorverstärker umfasst zweckmäßigerweise einen Transistor. Mittels des A/D-Wandlers wird bei Betrieb insbesondere ein analoges Signal in ein digitales Signal gewandelt. Vorzugsweise umfasst der A/D-Wandler einen Operationsverstärker. Mittels des Verstärkers wird bei Betrieb geeigneterweise ein digitales Signal verändert und geeigneterweise verstärkt. Die Rauschunterdrückungseinheit ist geeignet sowie vorgesehen und eingerichtet, ein Rauschen innerhalb eines Signals zu dämpfen, wobei das Signal insbesondere ein digitales Signal ist.

Beispielsweise ist das Hörgerät ein Kopfhörer oder umfasst einen Kopfhörer. Besonders bevorzugt ist das Hörgerät jedoch ein Hörhilfegerät. Das Hörhilfegerät dient der Unterstützung einer unter einer Verminderung des Hörvermögens leidenden Person. Mit anderen Worten ist das Hörhilfegerät ein medizinisches Gerät, mittels dessen beispielsweise ein partieller Hörverlust ausgeglichen wird. Das Hörhilfegerät ist beispielsweise ein "receiver-in-the-canal"-Hörhilfegerät (RIC; Ex-Hörer- Hörhilfegerät), ein Im-Ohr-Hörhilfegerät, wie ein "in-the-ear"-Hörhilfegerät, ein "in-the-canal"-Hörhilfegerät (ITC) oder ein "complete-in-canal"-Hörhilfegerät (CIC), eine Hörbrille, ein Taschenhörhilfegerät, ein Knochenleitungs-Hörhilfegerät oder ein Implantat. Besonders bevorzugt ist das Hörhilfegerät ein Hinter-dem-Ohr-Hörhilfegerät ("Behind-the-Ear"-Hörhilfegerät), das hinter einer Ohrmuschel getragen wird.

Das Hörgerät ist vorgesehen und eingerichtet, am menschlichen Körper getragen zu werden. Mit anderen Worten umfasst das Hörgerät bevorzugt eine Haltevorrichtung, mittels deren eine Befestigung am menschlichen Körper möglich ist. Sofern es sich bei dem Hörgerät um ein Hörhilfegerät handelt, ist das Hörgerät vorgesehen und eingerichtet, beispielsweise hinter dem Ohr oder innerhalb eines Gehörgangs angeordnet zu werden. Insbesondere ist das Hörgerät kabellos und dafür vorgesehen und eingerichtet, zumindest teilweise in einen Gehörgang eingeführt zu werden. Beispielsweise ist das Hörgerät ein Bestandteil eines Hörgerätesystems, das ein weiteres Hörgerät oder ein weiteres Gerät umfasst, wie ein Richtmikrofon oder ein sonstiges, ein Mikrofon aufweisendes Gerät.

Das Hörgerät ist geeignet sowie vorgesehen und eingerichtet, ein Verfahren durchzuführen, das vorsieht, dass ein erstes analoges Signal bereitgestellt wird. Beispielsweise umfasst das Hörgerät ein Mikrofon, mittels dessen das erste analoge Signal bereitgestellt wird. Anhand des ersten analogen Signals wird mittels des Vorverstärkers ein zweites analoges Signal erstellt, und mittels des A/D-Wandlers wird anhand des zweiten analogen Signals ein erstes digitales Signal erstellt. Anhand des ersten digitalen Signals wird mittels des Verstärkers ein zweites digitales Signal erstellt, und anhand des zweiten digitalen Signals wird mittels der Rauschunterdrückungseinheit ein drittes digitales Signal erstellt wird, bei dem im Vergleich zu dem zweiten digitalen Signal ein Rauschen reduziert ist. Der Vorverstärker, der Verstärker und die Rauschunterdrückungseinheit werden anhand eines das erste digitale Signal charakterisierenden Werts eingestellt.

Beispielsweise umfasst das Hörgerät einen Frequenzfilter, mittels dessen das zweite digitale Signal aufgespalten wird. Diese Frequenzkanäle des zweiten digitalen Signals werden mittels der Rauschunterdrückungseinheit zur Erstellung des dritten digitalen Signals bearbeitet, wobei das Rauschen vorzugsweise frequenzselektiv reduziert wird. Zweckmäßigerweise wird das dritte digitale Signal an einen Signalprozessor (DSP) geleitet, mittels dessen ein viertes Signal erstellt wird, mittels dessen beispielsweise spezielle Anforderungen erfüllt werden. Insbesondere ist das vierte Signal an eine etwaige Beeinträchtigung des Hörgeräteträgers angepasst. Vorzugsweise wird das dritte bzw. vierte Signal an einen Hörer weitergeleitet. Mittels des Hörers werden bei Betrieb Schallwellen erzeugt, die bevorzugt in das Ohr des Hörgeräteträgers eingeleitet werden. Insbesondere ist der Hörer ein elektromechanischer Schallwandler.

Die im Zusammenhang mit dem Verfahren beschriebenen Weiterbildungen und Vorteile sind sinngemäß auch auf das Hörgerät zu übertragen und umgekehrt.

Nachfolgend werden Ausführungsbeispiele der Erfindung anhand einer Zeichnung näher erläutert. Darin zeigen:
- Fig. 1: schematisch ein Hörgerät mit einem Vorverstärker, mit einem A/D-Wandler, mit einem Verstärker, und mit einer Rauschunterdrückungseinheit,
- Fig. 2: ein Frequenzspektrum eines Rauschens in Abhängigkeit einer Einstellung des Vorverstärkers,
- Fig. 3: ein Verfahren zum Betrieb des Hörgeräts,
- Fig. 4: schematisch die Rauschunterdrückungseinheit, und
- Fig. 5: den zeitlichen Verlauf einer Rauschunterdrückung in Abhängigkeit einer Einstellung des Vorverstärkers und der Rauschunterdrückungseinheit.

Einander entsprechende Teile sind in allen Figuren mit den gleichen Bezugszeichen versehen.

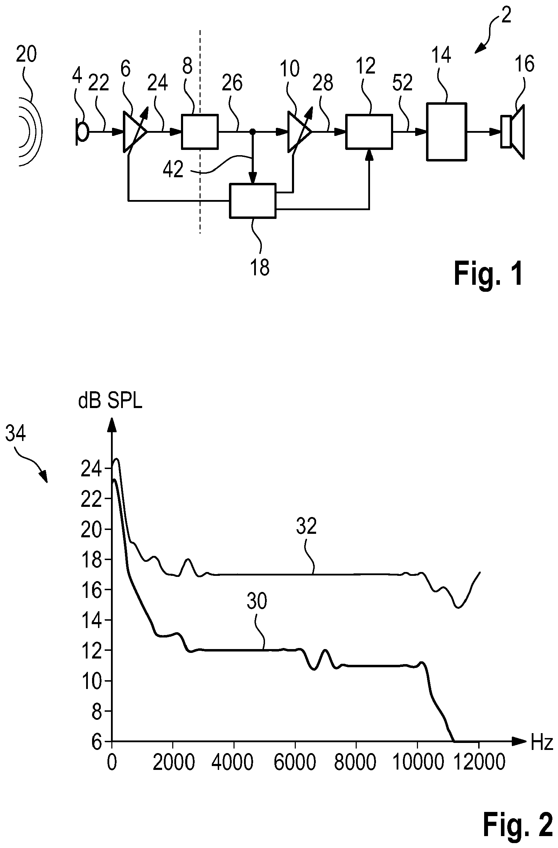

In Fig. 1 ist schematisch vereinfacht ein Hörgerät 2 in Form eines Hörhilfegeräts schematisch gezeigt. Das Hörhilfegerät 2 dient der Unterstützung einer unter einer Beeinträchtigung des Gehörs leidenden Person. Das Hörgerät 2 weist ein Mikrofon 4 sowie diesem signaltechnisch nachgeschaltet einen Vorverstärker 6 auf. Dem Vorverstärker 6 ist signaltechnisch ein A/D-Wandler 8 nachgeschaltet, und diesem ein Verstärker 10. Dem Verstärker 10 ist signaltechnisch eine Rauschunterdrückungseinheit 12 und dieser ein digitaler Soundprozessor (DSP) 14 nachgeschaltet. Diesem ist signaltechnisch ein Hörer 16 nachgeschaltet. Das Hörgerät 2 weist ferner eine Steuereinheit 18 auf.

Bei Betrieb des Hörgeräts 2 wird mittels des Mikrofons 4 ein Schall 20 erfasst. Dieser wird in ein erstes analoges Signal 22 umgewandelt. Mit anderen Worten wird das erste analoge Signal 22 mittels des Mikrofons 4 bereitgestellt und zu dem Vorverstärker 6 geleitet. Mittels des Vorverstärkers 6 wird anhand des ersten analogen Signals 22 ein zweites analoges Signal 24 erstellt, welches zu dem A/D-Wandler 8 geleitet wird. Hierbei entspricht das zweite analoge Signal 24 dem verstärkten ersten analogen Signal 22. Mittels des A/D-Wandlers 8 wird anhand des zweiten analogen Signals 24 ein erstes digitales Signal 26 erstellt. Das erste digitale Signal 26 entspricht dem zweiten analogen Signal 24, welches in die digitale Domäne transferiert ist. Hierbei wird mittels des A/D-Wandlers 8 ein Rauschen in das erste digitale Signal 26 eingebracht. Das erste digitale Signal 26 wird zu dem Verstärker 10 geleitet und mittels dessen ein zweites digitales Signal 28 erstellt, das dem verstärkten ersten digitalen Signal 26 entspricht.

Der Vorverstärker 6 weist zwei Einstellungsstufen auf, nämlich eine erste Einstellung 30 und eine zweite Einstellung 32, mittels derer das Verstärkungsverhältnis zwischen dem zweiten analogen Signal 24 und dem ersten analogen Signal 22 eingestellt wird. Ferner weist der Verstärker 10 ebenfalls die zwei Einstellungsstufen auf, die zu denen des Vorverstärkers 6 korrespondieren. Hierbei wird der Verstärker 10 mittels der Steuereinheit 18 derart eingestellt, dass das Verstärkungsverhältnis zwischen dem ersten analogen Signal 22 und dem zweiten digitalen Signal 28 konstant ist. Unterscheiden sich somit die beiden Verstärkungsstufen (Einstellungen) des Vorverstärkers 6 um beispielsweise 10 dB, wobei bei der zweiten Einstellung 32 der niedrigere Verstärkungsfaktor des Vorverstärkers 6 gewählt ist, so unterscheiden sich auch die Verstärkungsstufen des Verstärkers 10 um 10 dB, wobei der zweiten Einstellung 32 des Verstärkers 10 die Verstärkung um 10 dB angehoben ist. Bei der ersten Einstellung 30 ist der Verstärkungsfaktor des Vorverstärkers 6 angehoben, und der des Verstärkers 10 abgesenkt.

Aufgrund der beiden Einstellungen 30, 32 ergibt sich ein in Fig. 2 dargestelltes Frequenzspektrum eines Rauschens 34. Hierbei ist das Rauschen 34 bei höheren Frequenzen erhöht, sofern der Vorverstärker 6 und der Verstärker 10 mit der zweiten Einstellung 32 betrieben werden, also falls der Vorverstärker 6 die geringere Verstärkung aufweist. In diesem Fall ist das mittels des A/D-Wandlers 8 in das erste digitale Signal 26 eingebrachte Rauschen in der Größenordnung des Rauschens des Mikrofons 4 und wird mittels des Verstärkers 10 vergleichsweise stark zu dem zweiten Signal 28 verstärkt. Falls hingegen die erste Einstellung 30 gewählt ist, und das zweite analoge Signal 24 einen vergleichsweise hohen Pegel aufweist, ist das Rauschen 34, das mittels des A/D-Wandlers eingebracht wird, vergleichsweise gering, sodass das Signal-zu-Rausch-Verhältnis des ersten digitalen Signals 26 sowie des zweiten digitalen Signals 28 verbessert ist. Mit anderen Worten weist das erste digitale Signal 26 ein vergleichsweise hohes Signal-zu-Rausch-Verhältnis auf. Mittels des Verstärkers 10 wird das erste digitale Signal 26 zu dem zweiten digitalen Signal 28 verstärkt.

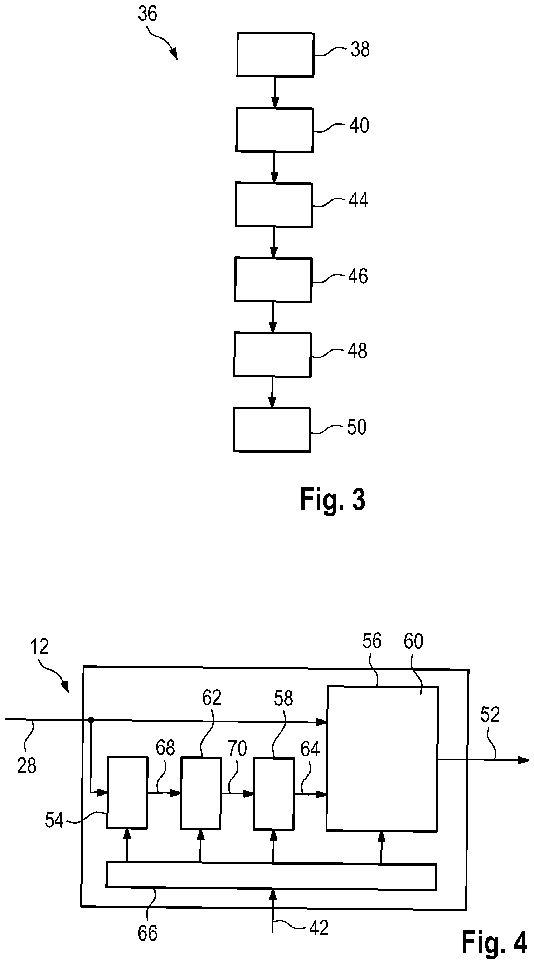

In Fig. 3 ist ein Verfahren 36 zum Betrieb des Hörgeräts 2 gezeigt. In einem ersten Arbeitsschritt 38 wird das erste analoge Signal 22 mittels des Mikrofons 4 bereitgestellt. In einem sich anschließenden zweiten Arbeitsschritt 40 wird ein charakterisierender Wert 42 des ersten digitalen Signals 26 ermittelt. Der charakterisierende Wert 42 ist der Pegel des ersten digitalen Signals 26. Hierfür wird beispielsweise der Pegel des ersten analogen Signals 22 erfasst. Anhand der Einstellungen sowie der Eigenschaften des Vorverstärkers 6 sowie des A/D-Wandlers 8 wird der sich ergebende Pegel des ersten digitalen Signals 26 berechnet. Alternativ hierzu wird der aktuelle Pegel des ersten digitalen Signals 26 erfasst und als Annäherung für das erste analoge Signal 22 herangezogen, welches zur selben Zeit bereitgestellt wird.

Anhand des charakterisierenden Werts 42 wird der Vorverstärker 6 sowie der Verstärker 10 eingestellt. Sofern der charakterisierende Wert 42 oberhalb eines Grenzwerts ist, wird die zweite Einstellung 32 und ansonsten die erste Einstellung 30 herangezogen. Sofern folglich der Schall 20 einen vergleichsweise niedrigen Pegel aufweist, weist auch das erste analoge Signal 22 einen vergleichsweise niedrigen Pegel auf. Da der Vorverstärker 6 mittels der ersten Einstellung 30 betrieben wird, ist der Verstärkungsfaktor des zweiten digitalen Signals 24 zu dem ersten analogen Signal 22 erhöht. Infolgedessen weist ein mittels des A/D-Wandlers 8 in das erste digitale Signal 26 eingebrachtes Rauschen einen vergleichsweise geringen Pegel auf. Mit anderen Worten weist das erste digitale Signal 26 ein vergleichsweise hohes Signal-zu-Rausch-Verhältnis auf. Mittels des Verstärkers 10 wird das erste digitale Signal 26 zu dem zweiten digitalen Signal 28 verstärkt.

Falls der Schall 20 einen hohen Pegel aufweist, und der Vorverstärker 6 mit der ersten Einstellung 30 betrieben ist, könnte auftreten, dass der A/D-Wandler 8 übersteuert wird, weswegen Artefakte in das erste digitale Signal 26 eingebracht würden, insbesondere ein sogenanntes "Clipping". Daher wird - sofern der charakterisierende Wert 42 oberhalb des Grenzwerts ist, der Vorverstärker 6 mit der zweiten Einstellung 32 betrieben, weswegen ein Verstärkungsverhältnis des zweiten analogen Signals 24 zu dem ersten analogen Signal 22 abgesenkt ist. Infolgedessen wird der A/D-Wandler 8 bei dessen optimalen Arbeitspunkten betrieben, auch wenn das erste digitale Signal 28 ein verschlechtertes Signal-zu-Rausch-Verhältnis aufweist. Mittels des Verstärkers 10 wird das erste digitale Signal 26 wiederum zu dem zweiten digitalen Signal 28 verstärkt, dessen Verstärkungsfaktor bezüglich des ersten analogen Signals 22 unabhängig von dem charakterisierenden Wert 42 ist.

Nach Ermittlung des charakterisierenden Werts 42 wird somit in einem dritten Arbeitsschritt 44 anhand des ersten analogen Signals 22 mittels des Vorverstärkers 6 das zweite analoge Signal 24 erstellt, wobei das zweite analoge Signal 24 dem verstärkten ersten analogen Signal 22 entspricht. In einem vierten Arbeitsschritt 46 wird das zweite analoge Signal 24 mittels des A/D-Wandlers in die digitale Domäne überführt und somit das erste digitale Signal 26 erstellt. Mittels des Verstärkers 10 wird in einem fünften Arbeitsschritt 48 das zweite digitale Signal 28 erstellt, welches zu der Rauschunterdrückungseinheit 12 geleitet wird.

Mittels der Rauschunterdrückungseinheit 12 wird in einem sechsten Arbeitsschritt 50 ein drittes digitales Signal 52 erstellt, bei dem im Vergleich zu dem zweiten digitalen Signal 28 das Rauschen 34 reduziert ist. Auch die Rauschunterdrückungseinheit 12 wird anhand des charakterisierenden Werts 42 eingestellt, wobei lediglich Änderungen des charakterisierenden Werts 42 an die Rauschunterdrückungseinheit 12 übermittelt wird. Insbesondere wird lediglich übermittelt, ob sich der charakterisierende Wert 42 oberhalb oder unterhalb des Grenzwerts befindet.

Zweckmäßigerweise wird ebenfalls lediglich die Änderung, also ein Über- bzw. Unterschreiten des Grenzwerts, an den Vorverstärker 6 sowie den Verstärker 10 mittels der Steuereinheit 18 übermittelt. Das dritte digitale Signal 52 wird zu dem digitalen Soundprozessor 14 geleitet, mittels dessen eine Anpassung an einen Hörschaden des Trägers des Hörgeräts 2 erfolgt. Dieses Signal wird mittels des Hörers 16 in den Gehörgang des Trägers des Hörgeräts 2 ausgegeben. Hierfür wird beispielsweise das mittels des digitalen Soundprozessors 14 bereitgestellte Signal in ein analoges Signal gewandelt, oder der Hörer 16 mit direkt mit dem digitalen Signal angesteuert.

In Fig. 4 ist die Rauschunterdrückungseinheit 12 schematisch dargestellt. Die Rauschunterdrückungseinheit 12 weist eine erste Pegelanpasseinheit 54, eine Unterdrückungseinheit 56 und eine zweite Pegelanpasseinheit 58 auf. Die Unterdrückungseinheit 56 umfasst ein Wiener-Filter 60. Die Rauschunterdrückungseinheit 12 umfasst einen Rausch-Pegel-Messer 62, mittels dessen ein Pegel eines Rauschens eines digitalen Signals erfasst wird, welches vorteilhafterweise ein Grundrauschen 64 eines digitalen Signals ist. Der Rausch-Pegel-Messer 62 ist signaltechnisch zwischen die erste Pegelanpasseinheit 54 und die zweite Pegelanpasseinheit 58 geschaltet. Zudem weist die Rauschunterdrückungseinheit 12 eine Adaptionseinheit 66 auf.

Bei Betrieb wird anhand des zweiten digitalen Signals 28 mittels der ersten Pegelanpasseinheit 54 ein erstes digitales Hilfssignal 68 erstellt, welches zu dem Rausch-Pegel-Messer 62 geleitet wird. Der Pegel des ersten digitalen Hilfssignals 68 ist hierbei im Vergleich zu dem des zweiten digitalen Signals 28 verändert, und das zweite digitale Signal 28 unterscheidet sich von dem ersten digitalen Hilfssignals 68 lediglich in dem Pegel. Mit dem Rausch-Pegel-Messer 62 wird innerhalb des ersten digitalen Hilfssignals 68 ein Rauschen identifiziert und dieses als zweites digitales Hilfssignal 70 zu der zweiten Pegelanpasseinheit 58 geleitet. Mittels der zweiten Pegelanpasseinheit 58 wird der Pegel des zweiten digitalen Hilfssignals 70 geändert, wobei das Grundrauschen 64 erstellt wird, welches ein digitales Signal ist. Hierbei unterscheidet sich das Grundrauschen 64 von dem zweiten digitalen Hilfssignal 70 lediglich in dem Pegel. Die Veränderung des Pegels mit der zweiten Pegelanpasseinheit 58 ist hierbei invers zu der Veränderung mit der ersten Pegelanpasseinheit 54.

Das Grundrauschen 64 und das zweite digitale Signal 28 wird zu der Unterdrückungseinheit 56 geleitet, wobei die Einstellung des Wiener-Filters 60 anhand des Grundrauschens 64 erfolgt. Mittels des Wiener-Filters 60 wird ein Rauschen in dem zweiten digitalen Signal 28 reduziert, und anhand des zweiten digitalen zweiten digitalen Signal 28 wird mittels der Unterdrückungseinheit 56 das dritte digitale Signal 52 erstellt, wobei das Rauschen reduziert ist. Die Ermittlung der Einstellung der ersten Pegelanpasseinheit 54, der Unterdrückungseinheit 56, der zweiten Pegelanpasseinheit 58 und des Rausch-Pegel-Messers 62 erfolgt adaptiv, wobei eine Adaptionsgeschwindigkeit mittels der Adaptionseinheit 66 gesteuert wird. Mit anderen Worten wird eine Änderung des Grundrauschens innerhalb des ersten digitalen Hilfssignals 68 mittels der Adaptionseinheit 66 berücksichtigt, sodass mittels des Rausch-Pegel-Messers 62 und der zweiten Pegelanpasseinheit 58 das Grundrauschen 64 stets effizient ermittelt wird.

Der charakterisierende Wert 42 wird beispielsweise zur Einstellung der ersten und zweiten Pegelanpasseinheit 54, 58 herangezogen. Hierbei wird mittels der ersten Pegelanpasseinheit 54 sichergestellt, dass das erste digitale Hilfssignal 68 stets den gleichen Rauschlevel aufweist, unabhängig von der Einstellung des Vorverstärkers 6 sowie des Verstärkers 10. Mit anderen Worten wird bei der zweiten Einstellung 32 mittels der ersten Pegelanpasseinheit 54 der Pegel abgesenkt. Mittels der zweiten Pegelanpasseinheit 58 wird die inverse Operation der ersten Pegelanpasseinheit 54 ausgeführt, sodass der Pegel des dritten digitalen Signals 52 im Wesentlichen des zweiten digitalen Signals 28 entspricht. Insbesondere erfolgt hierbei keine Änderung der Einstellung der Unterdrückungseinheit 56, sodass diese unabhängig von dem charakterisierenden Wert 42 eingestellt ist. Aufgrund des im Wesentlichen konstanten Rauschpegels in dem ersten digitalen Hilfssignal 68, auch bei einem Umschalten des Vorverstärkers 6, ist ein kontinuierlicher Betrieb des Rausch-Pegel-Messers 62 gewährleistet. Mit Hilfe der zweiten Pegelanpasseinheit 58 wird somit das Grundrauschen 64 bereitgestellt, welches auch bei geänderter Ansteuerung des Vorverstärkers 6 sowie des Verstärkers 10 korrekt abbildet ist. Auf dieser Basis ist die Rauschunterdrückungseinheit 56 in der Lage, das dritte digitale Signal 52 bereitzustellen, das vergleichsweise wenige Artefakte umfasst.

Alternativ oder in Kombination hierzu wird anhand des charakterisierenden Werts 42 eine Adaptionsgeschwindigkeit des Rausch-Pegel-Messer 62 mittels der Adaptionseinheit 66 eingestellt. Hierfür werden zweckmäßigerweise die Zeitkonstanten, die zur Adaption herangezogen werden, verkürzt, sofern ein Umschalten des Vorverstärkers 6 sowie des Verstärkers 10 erfolgt, also insbesondere falls der charakterisierende Wert 42 den Grenzwert unter- bzw. überschreitet. Nach einer vergleichsweise kurzen Zeitspanne nach Unter- bzw. Überschreiten wird die Adaptionsgeschwindigkeit 66 bevorzugt erneut auf den ursprünglichen Wert eingestellt. Infolgedessen wird ein etwaiger Sprung im Verhalten des Rauschens 34 aufgrund der geänderten Ansteuerung des Vorverstärkers 6 sowie des Verstärkers 10, wie in Fig. 2 gezeigt, vergleichsweise schnell ausgeregelt. Somit sind in dem dritten digitalen Signal 52 aufgrund des Umschaltens vergleichsweise wenige Artefakte aufgrund einer fehlerhaften Ermittlung des Grundrauschens 64 vorhanden.

In einer weiteren Alternative wird anhand des charakterisierenden Werts 42 eine erwartete Rauschform angepasst. Mit anderen Worten wird zwischen den beiden in Fig. 2 gezeigten Frequenzspektren des Rauschens 34 umgeschaltet, je nachdem ob der Vorverstärker 6 sowie der Verstärker 10 anhand der ersten Einstellung 30 oder der zweiten Einstellung 32 betrieben sind. Hierfür wird dem Wiener-Filter 60 ein durch die Pegelanpasseinheiten 54, 58 korrigiertes Grundrauschen 64 zur Verfügung gestellt. Zusammenfassend wird die Rauschunterdrückungseinheit 12 anhand des charakterisierenden Werts 42 eingestellt, anhand dessen auch der Vorverstärker 6 sowie der Verstärker 10 eingestellt werden. Infolgedessen wird mittels der Rauschunterdrückungseinheit 12 das Rauschen 34 innerhalb des zweiten digitalen Signals 28 im Wesentlichen konstant reduziert, unabhängig davon, ob der Vorverstärker 6 und der Verstärker 10 mit der ersten Einstellung 30 oder der zweiten Einstellung 32 betrieben sind.

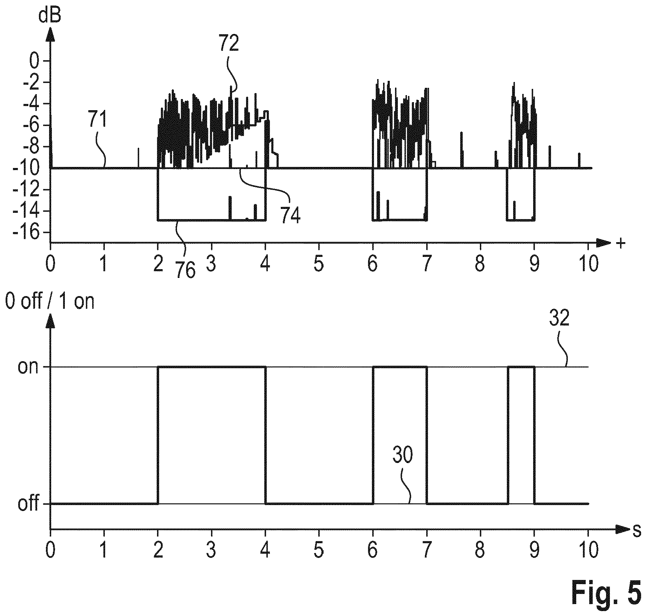

In Fig. 5 ist beispielhaft ein zeitlicher Verlauf der Rauschunterdrückung 71 der Unterdrückungseinheit 56 und der Einstellung des Vorverstärkers 6 sowie des Verstärkers 10 gezeigt. Hierbei ist eine erste Variante 72 der Rauschunterdrückung 71 gezeigt, falls die Rauschunterdrückungseinheit 12 unabhängig von dem charakterisierenden Wert 42 betrieben wird. Sobald von der ersten Einstellung 30 auf die zweite Einstellung 32 umgeschaltet wird, ist das Signal-zu-Rausch-Verhältnis des zweiten digitalen Signals 28 verschlechtert. Infolgedessen wird das Rauschen 34 nicht vollständig als Rauschen erkannt, weswegen dieses in der ersten Variante72 des dritten digitalen Signals 52 dann vorhanden ist, falls die zweite Einstellung 32 gewählt ist.

Sofern die Rauschunterdrückungseinheit 12 anhand des charakterisierenden Werts 42 angepasst wird, ergibt sich eine zweite Variante 74 der Rauschunterdrückung 71. Hierbei arbeitet der Wiener-Filter 60 mit konstanter Rauschunterdrückung, sodass das Rauschen 34 konstant reduziert ist, unabhängig von der Einstellung 30, 32 des Vorverstärkers 6 und Verstärkers 10. Das dritte digitale Signal 52 weist dabei dieselben Änderungen des Rauschens 34 auf. Die zweite Variante 74 unterscheidet sich von der ersten Variante 72 beispielsweise dadurch, dass die beiden Pegelanpasseinheiten 54, 58 angepasst sind. Ferner ist eine dritte Variante 76 der Rauschunterdrückung 71 dargestellt, bei der die Reduktion des Rauschens 34 in Abhängigkeit des charakterisierenden Werts 42 eingestellt ist. Hierbei ist jedes Mal dann, wenn der charakterisierende Wert 42 oberhalb des Grenzwerts ist, die Reduktion erhöht. Mit anderen Worten wird das Rauschen in der Unterdrückungseinheit stärker abgesenkt, wenn die zweite Einstellung 32 herangezogen wird. Die Absenkung beträgt beispielsweise 10 dB. Infolgedessen ist der Anteil der Reduktion des Rauschens 34 erhöht, sodass ein im Wesentlichen konstantes Grundrauschen innerhalb des dritten digitalen Signals 52 erreicht ist.

Zusammenfassend wird die Rauschunterdrückungseinheit 12 anhand der Einstellung des Vorverstärkers 6 sowie des Verstärkers 10 angepasst, also anhand des Arbeitspunkts der Einheit, die den Vorverstärker 6, den A/D-Wandler 8 sowie den Verstärker 10 umfasst. Hierbei wird insbesondere das erwartete Spektrum des Rauschens 34 innerhalb der Rauschunterdrückungseinheit 12 und/oder eine etwaige Schwelle des Rauschens 34, also ein Grundrauschen, angepasst. Dies berücksichtigt, dass bei einer Verringerung des Verstärkungsfaktors des Vorverstärkers 6 das Rauschen 34 verstärkt wird. Infolgedessen ist ein im Wesentlichen konstantes Grundrauschen innerhalb des dritten digitalen Signals 52 vorhanden, unabhängig, ob der Vorverstärker 6 und der Verstärker 10 mit der ersten Einstellung 30 oder der zweiten Einstellung 32 betrieben sind.

Die Umschaltung zwischen der ersten Einstellung 30 und der zweiten Einstellung 32 erfolgt im Wesentlichen schlagartig, weswegen auch der in dem zweiten digitalen Signal 28 vorhandene Anteil des Rauschens 34 schlagartig erhöht ist. Dies wird zweckmäßigerweise mittels der Pegelanpasseinheit 54 berücksichtigt, sodass das dem Rausch-Pegel-Messer 62 zugeleitete erste digitale Hilfssignal 68 im Wesentlichen ein konstantes Rauschen aufweist. Mittels der zweiten Pegelanpasseinheit 58 wird die Absenkung (Korrektur), die mittels der ersten Pegelanpasseinheit 54 durchgeführt wurde, kompensiert. Infolgedessen ist eine Funktionsweise des Rausch-Pegel-Messers 62 verbessert.

Auch kann mittels der Adaptionseinheit 66 die Adaptionsgeschwindigkeit der beiden Rausch-Pegel-Messer 62 verändert werden. Insbesondere wird die Adaptionsgeschwindigkeit verkürzt, falls der charakterisierende Wert 42 den Schwellwert unter- oder überschreitet. Auf diese Weise erfolgt eine schnellere Adaption an die geänderte Einstellung, also an den Arbeitspunkt der Einheit. Mittels Bereitstellung des Spektrums des Rauschens 34, welcher zu der jeweiligen Einstellung 30,32 korrespondiert, ist ein vergleichsweise effizientes Unterdrücken des Rauschens 34 ermöglicht. Hierbei werden beispielsweise die beiden Spektren des Rauschens 34 zunächst gemessen und in der Rauschunterdrückungseinheit 12 hinterlegt, wobei das Messen beispielsweise nach der Fertigung des Hörgeräts 2 erfolgt. Insbesondere erfolgt die Unterdrückung des Rauschens 34 frequenzspezifisch. Mit anderen Worten weist die Rauschunterdrückungseinheit 12 eine Anzahl an Unterdrückungseinheiten 56 auf, mittels derer jeweils ein bestimmter Frequenzbereich des zweiten digitalen Signals 28 analysiert und bearbeitet wird. Aufgrund der Überkompensation, also der Erhöhung des Anteils der Reduktion des Rauschens 34, ist ein im Wesentlichen konstantes Grundrauschen innerhalb des dritten digitalen Signals 52 bereitgestellt. Hierbei wird die maximale Reduktion vorzugsweise auf den Wert eingestellt, um dem sich die beiden Spektren des Rauschens 34 der beiden Einstellungen 30,32 unterscheiden.

Die Erfindung ist nicht auf die vorstehend beschriebenen Ausführungsbeispiele beschränkt. Vielmehr können auch andere Varianten der Erfindung von dem Fachmann hieraus abgeleitet werden, ohne den Gegenstand der Erfindung, der in den nachfolgenden Ansprüchen definiert ist, zu verlassen.

### Bezugszeichenliste

- 2: Hörgerät
- 4: Mikrofon
- 6: Vorverstärker
- 8: A/D-Wandler
- 10: Verstärker
- 12: Rauschunterdrückungseinheit
- 14: Digitaler Soundprozessor
- 16: Hörer
- 18: Steuereinheit
- 20: Schall
- 22: erstes analoges Signal
- 24: zweites analoges Signal
- 26: erstes digitales Signal
- 28: zweites digitales Signal
- 30: erste Einstellung
- 32: zweite Einstellung
- 34: Rauschen
- 36: Verfahren
- 38: erster Arbeitsschritt
- 40: zweiter Arbeitsschritt
- 42: charakterisierender Wert
- 44: dritter Arbeitsschritt
- 46: vierter Arbeitsschritt
- 48: fünfter Arbeitsschritt
- 50: sechster Arbeitsschritt
- 52: drittes digitales Signal
- 54: erste Pegelanpasseinheit
- 56: Unterdrückungseinheit
- 58: zweite Pegelanpasseinheit
- 60: Wiener-Filter
- 62: Rausch-Pegel-Messer
- 64: Grundrauschen
- 66: Adaptionseinheit
- 68: erstes digitales Hilfssignal
- 70: zweites digitales Hilfssignal
- 71: Rauschunterdrückung
- 72: erste Variante der Rauschunterdrückung
- 74: zweite Variante der Rauschunterdrückung
- 76: dritte Variante der Rauschunterdrückung

## Patentansprüche

1. Verfahren (36) zum Betrieb eines Hörgeräts (2), insbesondere Hörhilfegerät, bei dem
- ein erstes analoges Signal (22) bereitgestellt wird,
- anhand des ersten analogen Signals (22) mittels eines analogen Vorverstärkers (6) ein zweites analoges Signal (24) erstellt wird,
- mittels eines A/D-Wandlers (8) anhand des zweiten analogen Signals (24) ein erstes digitales Signal (26) erstellt wird,
- anhand des ersten digitalen Signals (26) mittels eines digitalen Verstärkers (10) ein zweites digitales Signal (28) erstellt wird, und
- anhand des zweiten digitalen Signals (28) mittels einer Rauschunterdrückungseinheit (12) ein drittes digitales Signal (52) erstellt wird, bei dem im Vergleich zu dem zweiten digitalen Signal (28) ein Rauschen (34) reduziert ist,
wobei der analoge Vorverstärker (6), der digitale Verstärker (10) und die Rauschunterdrückungseinheit (12) anhand eines das erste digitale Signal (26) charakterisierenden Werts (42) eingestellt werden,
wobei als charakterisierender Wert (42) ein Pegel des ersten digitalen Signals (26) herangezogen wird,
wobei anhand des zweiten digitalen Signals (28) mittels einer ersten Pegelanpasseinheit (54) der Rauschunterdrückungseinheit (12) ein erstes digitales Hilfssignal (68) erstellt wird,
wobei anhand des ersten digitalen Hilfssignals (68) mittels eines Rausch-Pegel-Messers (62) der Rauschunterdrückungseinheit (12) ein zweites digitales Hilfssignal (70) erstellt wird, das einem Grundrauschen innerhalb des ersten digitalen Hilfssignals (68) entspricht, indem mit dem Rausch-Pegel-Messer (62) innerhalb des ersten digitalen Hilfssignals (68) ein Rauschen identifiziert und dieses als zweites digitales Hilfssignal (70) zu einer zweiten Pegelanpasseinheit (58) geleitet wird,
wobei anhand des zweiten digitalen Hilfssignals (70) mittels der zweiten Pegelanpasseinheit (58) ein Grundrauschen (64) erstellt wird, welches zu dem Rauschen (34) des zweiten digitalen Signals (28) korrespondiert, wobei die erste Pegelanpasseinheit (54) und die zweite Pegelanpasseinheit (58) anhand des charakterisierenden Werts (42) eingestellt werden, wobei zur Erstellung des dritten digitalen Signals (52) anhand des zweiten digitalen Signals (28) ein Wiener-Filter (60) herangezogen wird, und wobei die Einstellung des Wiener-Filters (60) anhand des Grundrauschens (64) erfolgt.

2. Verfahren (36) nach Anspruch 1, wobei das erste analoge Signal (22) mittels eines Mikrofons (4) bereitgestellt wird.

3. Verfahren (36) nach Anspruch 1 oder 2,wobei der digitale Verstärker (10) derart eingestellt wird, dass ein Verstärkungsverhältnis zwischen dem ersten analogen Signal (22) und dem zweiten digitalen Signal (28) konstant ist.

4. Verfahren (36) nach einem der Ansprüche 1 bis 3, wobei eine Änderung des charakterisierenden Werts (42) an die Rauschunterdrückungseinheit (12) übermittelt wird.

5. Verfahren (36) nach einem der Ansprüche 1 bis 4, wobei die erste Pegelanpasseinheit (54) und die zweite Pegelanpasseinheit (58) anhand des charakterisierenden Werts (42) eingestellt werden, und wobei eine Unterdrückungseinheit (56) der Rauschunterdrückungseinheit (12) unabhängig von dem charakterisierenden Wert (42) eingestellt wird.

6. Verfahren (36) nach einem der Ansprüche 1 bis 5, wobei der Anteil der Reduktion des Rauschens (34) in Abhängigkeit des charakterisierenden Werts (42) eingestellt wird.

7. Hörgerät (2), insbesondere Hörhilfegerät, mit einem analoge Vorverstärker (6), mit einem diesem signaltechnisch nachgeschalteten A/D-Wandler (8), mit einem diesem signaltechnisch nachgeschalteten digitalen Verstärker (10), und mit einer diesem nachgeschalteten Rauschunterdrückungseinheit (12), das vorgesehen und eingerichtet ist, ein Verfahren (36) nach einem der Ansprüche 1 bis 6 durchzuführen.

## Claims

1. Method (36) for operating a hearing device (2), in particular a hearing aid, in which
- a first analogue signal (22) is provided,
- the first analogue signal (22) is taken as a basis for producing a second analogue signal (24) by means of an analogue preamplifier (6),
- an A/D converter (8) is used to produce a first digital signal (26) on the basis of the second analogue signal (24),
- the first digital signal (26) is taken as a basis for producing a second digital signal (28) by means of a digital amplifier (10), and
- the second digital signal (28) is taken as a basis for producing a third digital signal (52) by means of a noise rejection unit (12), a noise (34) being reduced in said third digital signal in comparison with the second digital signal (28),
wherein the analogue preamplifier (6), the digital amplifier (10) and the noise rejection unit (12) are adjusted on the basis of a value (42) characterizing the first digital signal (26),
wherein the characterizing value (42) used is a level of the first digital signal (26),
wherein the second digital signal (28) is taken as a basis for producing a first digital auxiliary signal (68) by means of a first level matching unit (54) of the noise rejection unit (12),
wherein the first digital auxiliary signal (68) is taken as a basis for producing a second digital auxiliary signal (70) by means of a noise level meter (62) of the noise rejection unit (12), said second digital auxiliary signal corresponding to a background noise within the first digital auxiliary signal (68), by virtue of the noise level meter (62) being used to identify a noise within the first digital auxiliary signal (68) and said noise being routed as second digital auxiliary signal (70) to a second level matching unit (58),
wherein the second digital auxiliary signal (70) is taken as a basis for producing a background noise (64) by means of the second level matching unit (58), said background noise corresponding to the noise (34) of the second digital signal (28), wherein the first level matching unit (54) and the second level matching unit (58) are adjusted on the basis of the characterizing value (42),
wherein a Wiener filter (60) is used to produce the third digital signal (52) on the basis of the second digital signal (28), and
wherein the Wiener filter (60) is adjusted on the basis of the background noise (64).

2. Method (36) according to Claim 1, wherein the first analogue signal (22) is provided by means of a microphone (4).

3. Method (36) according to Claim 1 or 2, wherein the digital amplifier (10) is adjusted such that a gain ratio between the first analogue signal (22) and the second digital signal (28) is constant.

4. Method (36) according to one of Claims 1 to 3, wherein a change in the characterizing value (42) is transmitted to the noise rejection unit (12).

5. Method (36) according to one of Claims 1 to 4, wherein the first level matching unit (54) and the second level matching unit (58) are adjusted on the basis of the characterizing value (42), and wherein a rejection unit (56) of the noise rejection unit (12) is adjusted independently of the characterizing value (42).

6. Method (36) according to one of Claims 1 to 5, wherein the proportion of the reduction of the noise (34) is adjusted on the basis of the characterizing value (42).

7. Hearing device (2), in particular hearing aid, having an analogue preamplifier (6), having an A/D converter (8) connected downstream of said analogue preamplifier for signalling purposes, having a digital amplifier (10) connected downstream of said A/D converter for signalling purposes and having a noise rejection unit (12) connected downstream of said digital amplifier, which noise rejection unit is intended and configured to perform a method (36) according to one of Claims 1 to 6.

## Revendications

1. Procédé (36) de fonctionnement d'un appareil auditif (2), en particulier d'une aide auditive, procédé dans lequel
- un premier signal analogique (22) est produit,
- un deuxième signal analogique (24) est généré sur la base du premier signal analogique (22) au moyen d'un préamplificateur analogique (6),
- un premier signal numérique (26) est généré au moyen d'un convertisseur A/N (8) sur la base du deuxième signal analogique (24),
- un deuxième signal numérique (28) est généré à partir du premier signal numérique (26) au moyen d'un amplificateur numérique (10), et
- un troisième signal numérique (52), dans lequel un bruit (34) est réduit par rapport au deuxième signal numérique (28), est généré sur la base du deuxième signal numérique (28) au moyen d'une unité de suppression de bruit (12),
le préamplificateur analogique (6), l'amplificateur numérique (10) et l'unité de suppression de bruit (12) étant réglés sur la base d'une valeur (42) caractérisant le premier signal numérique (26),
un niveau du premier signal numérique (26) étant utilisé comme valeur de caractérisation (42),
un premier signal numérique auxiliaire (68) étant généré sur la base du deuxième signal numérique (28) au moyen d'une première unité de réglage de niveau (54) de l'unité de suppression de bruit (12),
un deuxième signal numérique auxiliaire (70), qui correspond à un bruit de fond dans le premier signal numérique auxiliaire (68), étant généré sur la base du premier signal numérique auxiliaire (68) au moyen d'un indicateur de niveau de bruit (62) de l'unité de suppression de bruit (12), l'indicateur de niveau (62) identifiant un bruit dans le premier signal numérique auxiliaire (68) et ce bruit étant transmis en tant que deuxième signal numérique auxiliaire (70) à une deuxième unité de réglage de niveau (58),
un bruit de fond (64), qui correspond au bruit (34) du deuxième signal numérique (28), étant généré au moyen de la deuxième unité de réglage de niveau (58) sur la base du deuxième signal numérique auxiliaire (70),
la première unité de réglage de niveau (54) et la deuxième unité de réglage de niveau (58) étant réglées sur la base de la valeur de caractérisation (42),
un filtre de Wiener (60) étant utilisé pour générer le troisième signal numérique (52) sur la base du deuxième signal numérique (28), et
le réglage du filtre de Wiener (60) étant basé sur le bruit de fond (64).

2. Procédé (36) selon la revendication 1, le premier signal analogique (22) étant produit au moyen d'un microphone (4).

3. Procédé (36) selon la revendication 1 ou 2, l'amplificateur numérique (10) étant réglé de telle sorte qu'un rapport d'amplification entre le premier signal analogique (22) et le deuxième signal numérique (28) soit constant.

4. Procédé (36) selon l'une des revendications 1 à 3, une variation de la valeur de caractérisation (42) étant transmise à l'unité de réduction de bruit (12).

5. Procédé (36) selon l'une des revendications 1 à 4, la première unité de réglage de niveau (54) et la deuxième unité de réglage de niveau (58) étant réglées sur la base de la valeur de caractérisation (42), et une unité de suppression (56) de l'unité de suppression de bruit (12) étant réglée indépendamment de la valeur de caractérisation (42).

6. Procédé (36) selon l'une des revendications 1 à 5, la proportion de réduction du bruit (34) étant réglée en fonction de la valeur de caractérisation (42).

7. Appareil auditif (2), en particulier aide auditive, comprenant un préamplificateur analogique (6), un convertisseur A/N (8) monté en aval de celui-ci par une technique de signal, un amplificateur numérique (10) monté en aval de celui-ci par une technique de signal, et une unité de suppression de bruit (12) montée en aval de celui-ci et prévue et conçue pour mettre en œuvre un procédé (36) selon l'une des revendications 1 à 6.
